# EUROPEAN PATENT SPECIFICATION

(11) **EP 4 518 604 B1**
(45) Date of publication and mention of the grant of the patent: **29.04.2026**
(21) Application number: 24196367.7
(22) Date of filing: 26.08.2024
(51) Int. Cl.: H10B 12/00

(54) **INTEGRATED CIRCUIT DEVICE AND METHOD OF MANUFACTURING THE SAME**
INTEGRIERTE SCHALTUNGSANORDNUNG UND VERFAHREN ZU DEREN HERSTELLUNG
DISPOSITIF DE CIRCUIT INTÉGRÉ ET SON PROCÉDÉ DE FABRICATION

(30) Priority: 29.08.2023 KR 20230113968
(43) Date of publication of application: 05.03.2025
(73) Proprietor: Samsung Electronics Co., Ltd, Suwon-si, Gyeonggi-do 16677 (KR)
(72) Inventor: LEE, Jinwook, 16677 Suwon-si, Gyeonggi-do (KR); MIN, Jongyeong, 16677 Suwon-si, Gyeonggi-do (KR); JUNG, Kyooho, 16677 Suwon-si, Gyeonggi-do (KR); PARK, Joonsuk, 16677 Suwon-si, Gyeonggi-do (KR); BAEK, Jiye, 16677 Suwon-si, Gyeonggi-do (KR); LEE, Yeseul, 16677 Suwon-si, Gyeonggi-do (KR)
(74) Representative: Kuhnen & Wacker Patent- und Rechtsanwaltsbüro PartG mbB

(56) References cited:
- US-A1- 2019 355 806
- US-A1- 2021 257 367
- US-A1- 2023 225 112

## Description

### BACKGROUND

The inventive concepts relate to an integrated circuit device, and more particularly, to an integrated circuit device including a capacitor.

With the recent rapid development of miniaturized semiconductor process technology, the high integration density of integrated circuit devices has been accelerated, and the area of each cell has decreased. Accordingly, an area that may be occupied by a capacitor in each cell has also decreased. For example, with the increase in the integration density of integrated circuit devices, such as dynamic random-access memory (DRAM), the area of each cell has decreased while necessary capacitance has been maintained or increased. What is therefore needed is a structure for maintaining desired electrical characteristics by overcoming the spatial limit of a capacitor and the limit of design rules and increasing the capacitance of the capacitor. US 2023225112 A1 discloses a semiconductor device including a substrate, lower electrodes disposed on the substrate, at least one support layer in contact with the lower electrodes, a dielectric layer disposed on the lower electrodes, an upper electrode disposed on the dielectric layer, a first interfacial film between the lower electrodes and the dielectric layer, and a second interfacial film between the upper electrode and the dielectric layer. At least one of the first and second interfacial films includes a plurality of layers, wherein the plurality of layers include a first metal element, and a second metal element, and at least one of oxygen \and nitrogen. The lower electrodes include the first metal element. A first region of the first interfacial film includes the second metal element at a first concentration and a second region of the first interfacial film includes the second metal element at a second concentration different from the first concentration.

### SUMMARY

The inventive concepts provide an integrated circuit device capable of reducing leakage current flowing through a capacitor dielectric film.

The inventive concepts are not limited to what is mentioned above and will be clearly understood by those skilled in the art from the descriptions below. The invention is defined in the appended independent claims. Further developments of the invention are specified in the dependent claims.

According to an aspect of the inventive concepts, there is provided an integrated circuit device comprising; a transistor on a substrate, and a capacitor structure electrically connected to the transistor.

According to another aspect of the inventive concept, there is provided an integrated circuit device comprising; a plurality of lower electrodes on a substrate, a supporter between the plurality of lower electrodes, an upper electrode on the plurality of lower electrodes, a capacitor dielectric film between the plurality of lower electrodes and the upper electrode, a lower interface film between the plurality of lower electrodes and the capacitor dielectric film, the lower interface film having a multi-layer structure having different nitrogen doping concentrations, and an upper interface film between the upper electrode and the capacitor dielectric film, the upper interface film having a multi-layer structure having different nitrogen doping concentrations. The lower interface film includes a first lower interface layer including metal oxide doped with an impurity, a second lower interface layer including a material that is identical to a material of the first lower interface layer and doped with nitrogen, and a third lower interface layer including a material that is identical to a material of the capacitor dielectric film and doped with nitrogen, the first to third lower interface layers being sequentially stacked on the plurality of lower electrodes, and wherein the upper interface film includes a first upper interface layer including metal oxide, a second upper interface layer including a material that is identical to a material of the first upper interface layer and doped with nitrogen, and a third upper interface layer including a material that is identical to the material of the capacitor dielectric film and doped with nitrogen, the first to third upper interface layers being sequentially stacked on the upper electrode, and wherein the metal oxide included in the first lower interface layer includes titanium oxide, the impurity included in the first lower interface layer includes a pentad, and a nitrogen doping concentration in the second lower interface layer is higher than a nitrogen doping concentration in the first lower interface layer.

### BRIEF DESCRIPTION OF THE DRAWINGS

Various example embodiments may be more clearly understood from the following detailed description taken in conjunction with the accompanying drawings in which:
FIG. 1 is a layout diagram of an integrated circuit device according to various example embodiments;
FIG. 2 is a cross-sectional view of the integrated circuit device according to various example embodiments;
FIG. 3 is an enlarged cross-sectional view of a region CX in FIG. 2;
FIGS. 4A and 4B are graphs showing the change in electrical characteristics according to the presence or absence of an upper interface film in an integrated circuit device, according to various example embodiments;
FIGS. 5A and 5B are graphs showing the change in electrical characteristics according to the presence or absence of a lower interface film in an integrated circuit device, according to various example embodiments;
FIGS. 6 and 7 are cross-sectional views of an integrated circuit device according to various example embodiments;
FIGS. 8 to 10 are cross-sectional views of an integrated circuit device according to various example embodiments;
FIGS. 11 to 13 are flowcharts of a method of manufacturing an integrated circuit device, according to various example embodiments;
FIGS. 14 to 24 are cross-sectional views of stages in a method of manufacturing an integrated circuit device, according to various example embodiments; and
FIG. 25 is a block diagram of a system including an integrated circuit device, according to various example embodiments.

### DETAILED DESCRIPTIONS

Hereinafter, various example embodiments are described in detail with reference to the accompanying drawings.

For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU) , an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

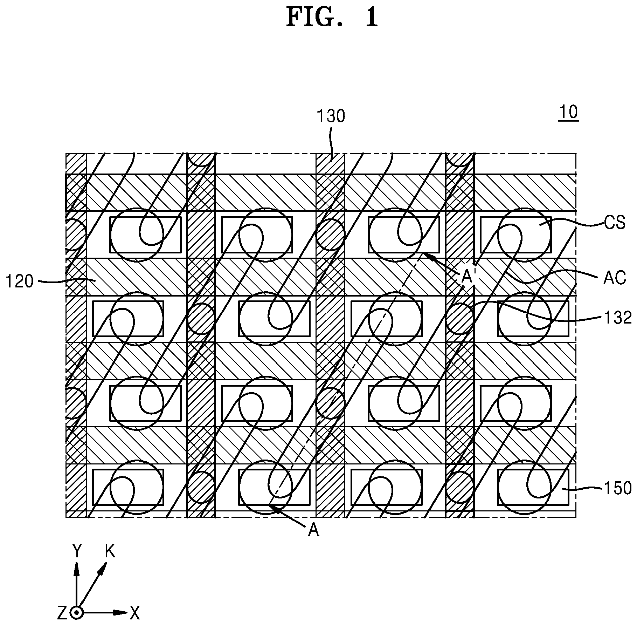

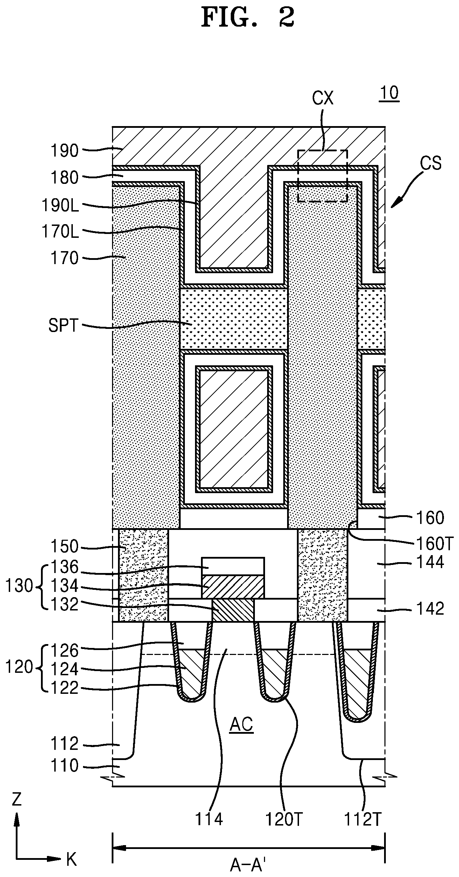

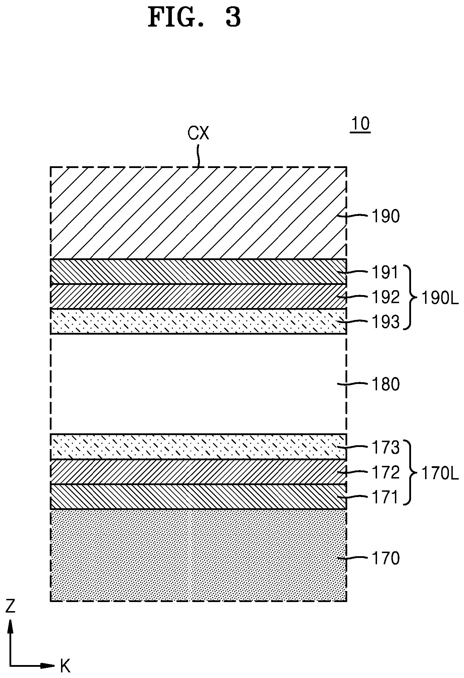

FIG. 1 is a layout diagram of an integrated circuit device 10 according to various example embodiments. FIG. 2 is a cross-sectional view of the integrated circuit device 10, taken along a line A-A' in FIG. 1. FIG. 3 is an enlarged view of a region CX in FIG. 2.

Referring to FIGS. 1 to 3, the integrated circuit device 10 includes a lower electrode 170 above a substrate 110, a supporter SPT supporting the lower electrode 170, a capacitor dielectric film 180 on the lower electrode 170, and an upper electrode 190 on the capacitor dielectric film 180.

The substrate 110 may include an active region AC defined by an isolation film 112. The substrate 110 may correspond to a wafer including silicon (Si). In some embodiments, the substrate 110 may correspond to a wafer including a semiconductor element, such as germanium (Ge), or a compound semiconductor, such as silicon carbide (SiC), gallium arsenide (GaAs), indium arsenide (InAs), or indium phosphide (InP). However, example embodiments are not limited thereto. The substrate 110 may have a silicon on insulator (SOI) structure. The substrate 110 may include a conductive region, e.g., an impurity-doped well or an impurity-doped structure.

For example, the isolation film 112 may have a shallow trench isolation (STI) structure. The isolation film 112 may include an insulating material filling an isolation trench 112T in the substrate 110. The insulating material may include fluoride silicate glass (FSG), undoped silicate glass (USG), boro-phospho-silicate glass (BPSG), phospho-silicate glass (PSG), flowable oxide (FOX), plasma enhanced tetra-ethyl-ortho-silicate (PE-TEOS), or tonen silazene (TOSZ) but example embodiments are not limited thereto.

The active region AC may have a relatively long island shape. The long axis of the active region AC may be arranged in a K-direction that is parallel with a top surface of the substrate 110. The active region AC may be doped with a p-type or an n-type impurity.

The substrate 110 may include a gate line trench 120T extending in an X-direction. The gate line trench 120T may cross the active region AC and have a certain depth from the top surface of the substrate 110. A portion of the gate line trench 120T may extend to the inside of the isolation film 112. The bottom of a gate line trench 120T in the isolation film 112 may be at a lower level than the bottom of a gate line trench 120T in the active region AC.

A source/drain region 114 may be on the active region AC at each of opposite sides of a gate line trench 120T. The source/drain region 114 may include an impurity region, which is doped with an impurity of a different conductivity type than the active region AC. The source/drain region 114 may be doped with an n-type or a p-type impurity.

A gate structure 120 may be formed in the gate line trench 120T. The gate structure 120 may include a gate insulating layer 122, a gate electrode layer 124, and a gate capping layer 126, which are sequentially formed on the inner wall of the gate line trench 120T.

The gate insulating layer 122 may be conformally formed on the inner wall of the gate line trench 120T to a certain thickness. The gate insulating layer 122 may include at least one selected from the group consisting of silicon oxide, silicon nitride, silicon oxynitride, oxide/nitride/oxide (ONO), and a high-k material having a higher dielectric constant than silicon oxide. However, example embodiments are not limited thereto.

The gate electrode layer 124 may be formed on the gate insulating layer 122 to fill the gate line trench 120T up to a certain height from the bottom of the gate line trench 120T. The gate electrode layer 124 may include a work function control layer (not shown) on the gate insulating layer 122 and a buried metal layer (not shown) on the work function control layer, wherein the buried metal layer fills a bottom portion of the gate line trench 120T.

The gate capping layer 126 may be on the gate electrode layer 124 and may fill the remaining portion of the gate line trench 120T. For example, the gate capping layer 126 may include at least one selected from the group consisting of silicon oxide, silicon oxynitride, and silicon nitride.

A bit line structure 130 may be on the source/drain region 114 and may extend in a Y-direction that is perpendicular to the X-direction. The bit line structure 130 may include a bit line contact 132, a bit line 134, and a bit line capping layer 136, which are sequentially stacked on the substrate 110. For example, the bit line contact 132 may include polysilicon, the bit line 134 may include a metal material, and the bit line capping layer 136 may include silicon nitride or silicon oxynitride.

A first interlayer insulating film 142 may be on the substrate 110. The bit line contact 132 may pass through the first interlayer insulating film 142 to be connected to the source/drain region 114. The bit line 134 and the bit line capping layer 136 may be on the first interlayer insulating film 142. A second interlayer insulating film 144 may be on the first interlayer insulating film 142 and may cover the side surfaces of the bit line 134 and the side and top surfaces of the bit line capping layer 136.

A contact structure 150 may be on the source/drain region 114. The first and second interlayer insulating films 142 and 144 may surround the side wall of the contact structure 150. In some embodiments, the contact structure 150 may include a lower contact (not shown), a metal silicide layer (not shown), and an upper contact (not shown), which are sequentially stacked on the substrate 110.

A capacitor structure CS may be on the second interlayer insulating film 144. The capacitor structure CS includes the lower electrode 170 electrically connected to the contact structure 150, the capacitor dielectric film 180 conformally covering the lower electrode 170, and the upper electrode 190 on the capacitor dielectric film 180. An etch stop film 160 having an opening 160T may be on the second interlayer insulating film 144, and a bottom portion of the lower electrode 170 may be in the opening 160T of the etch stop film 160.

It is illustrated that a plurality of capacitor structures CS are respectively arranged on a plurality of contact structures 150, which are repeatedly arranged in the X- and Y-directions, but example embodiments are not limited thereto. Differently, a plurality of capacitor structures CS may be arranged in a honeycomb pattern on a plurality of contact structures 150, which are repeatedly arranged in the X- and Y-directions.

The lower electrode 170 may include metal nitride, metal, or a combination thereof. For example, the lower electrode 170 may include at least one selected from the group consisting of TiN, TaN, WN, Ru, Pt, and Ir. The lower electrode 170 may be formed by chemical vapor deposition (CVD) or atomic layer deposition (ALD). However, example embodiments are not limited thereto.

The lower electrode 170 may have a very large aspect ratio. For example, the aspect ratio of the lower electrode 170 may be about 10 to about 30. In detail, the diameter of the lower electrode 170 may be about 20 nm to about 100 nm, and the height of the lower electrode 170 may be about 500 nm to about 4000 nm, but the lower electrode 170 is not limited to these dimensions. As the lower electrode 170 has a large aspect ratio, the lower electrode 170 may collapse or break.

The supporter SPT may prevent the lower electrode 170 from collapsing or breaking. The supporter SPT may have a plate shape including a supporter pattern in contact with the lower electrode 170.

The capacitor dielectric film 180 is on an outer surface of each of the lower electrode 170 and the supporter SPT. The capacitor dielectric film 180 may have a single-layer structure or a multi-layer structure. The capacitor dielectric film 180 may include a high-k material having a higher dielectric constant than silicon oxide. For example, the capacitor dielectric film 180 may have a dielectric constant of about 10 to about 25.

In some embodiments, the capacitor dielectric film 180 may include at least one selected from the group consisting of zirconium oxide, hafnium oxide, and aluminum oxide. For example, the capacitor dielectric film 180 may have, but not limited to, a single-layer structure of zirconium oxide, a two-layer structure of zirconium oxide and aluminum oxide, or a three-layer structure of zirconium oxide, hafnium oxide, and aluminum oxide. However, example embodiments are not limited thereto.

The upper electrode 190 is on the capacitor dielectric film 180. The upper electrode 190 may be conformally formed on the capacitor dielectric film 180 and covers the lower electrode 170 with the capacitor dielectric film 180 between the upper electrode 190 and the lower electrode 170. The upper electrode 190 may include metal nitride, metal, or a combination thereof. For example, the upper electrode 190 may include at least one selected from the group consisting of TiN, TaN, WN, Ru, Pt, and Ir. However, example embodiments are not limited thereto.

In addition, in the integrated circuit device 10 of the inventive concepts, a lower interface film 170L is between the lower electrode 170 and the capacitor dielectric film 180 and an upper interface film 190L is between the upper electrode 190 and the capacitor dielectric film 180.

The lower interface film 170L is described first below. The lower interface film 170L has a three-layer structure of a first lower interface layer 171, a second lower interface layer 172, and a third lower interface layer 173. In detail, the lower interface film 170L includes a structure, in which the first lower interface layer 171, the second lower interface layer 172, and the third lower interface layer 173 are sequentially stacked on the lower electrode 170, wherein the first lower interface layer 171 includes metal oxide doped with an impurity, the second lower interface layer 172 includes a material that is identical to the material of the first lower interface layer 171 and doped with nitrogen, and the third lower interface layer 173 includes a material that is identical to the material of the capacitor dielectric film 180 and doped with nitrogen.

Here, the metal oxide included in the first lower interface layer 171 may include titanium oxide and the impurity included in the first lower interface layer 171 includes a pentad. In detail, the impurity included in the first lower interface layer 171 may include, but not limited to, vanadium (V), niobium (Nb), tantalum (Ta), phosphorus (P), or antimony (Sb). However, example embodiments are not limited thereto.

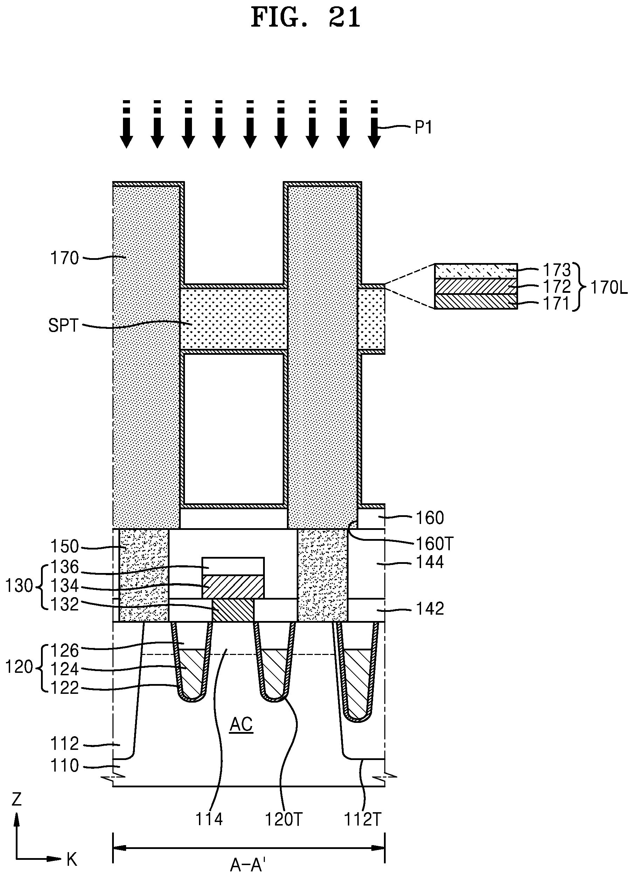

A nitrogen doping concentration in the second lower interface layer 172 is higher than a nitrogen doping concentration in the first lower interface layer 171. In other words, the first lower interface layer 171 and the second lower interface layer 172 may be distinguished from each other by the difference in nitrogen doping concentration therebetween. A nitrogen doping concentration in the third lower interface layer 173 may be higher than a nitrogen doping concentration in the capacitor dielectric film 180 facing the third lower interface layer 173. In other words, the third lower interface layer 173 and the capacitor dielectric film 180 may be distinguished from each other by the difference in nitrogen doping concentration therebetween. According to the characteristics of manufacturing processes, doping of nitrogen included in the second lower interface layer 172 and doping of nitrogen included in the third lower interface layer 173 may be simultaneously performed by a single first heat treatment (P1 in FIG. 21), which is described below.

The upper interface film 190L is described below. The upper interface film 190L has a three-layer structure of a first upper interface layer 191, a second upper interface layer 192, and a third upper interface layer 193. In detail, the upper interface film 190L includes a structure, in which the first upper interface layer 191, the second upper interface layer 192, and the third upper interface layer 193 are sequentially stacked on the upper electrode 190, wherein the first upper interface layer 191 includes metal oxide, the second upper interface layer 192 includes a material that is identical to the material of the first upper interface layer 191 and doped with nitrogen, and the third upper interface layer 193 includes a material that is identical to the material of the capacitor dielectric film 180 and doped with nitrogen.

Here, the metal oxide included in the first upper interface layer 191 may include, but not limited to, titanium oxide, tantalum oxide, or niobium oxide. Unlike the first lower interface layer 171, the first upper interface layer 191 may not include a pentad as an impurity.

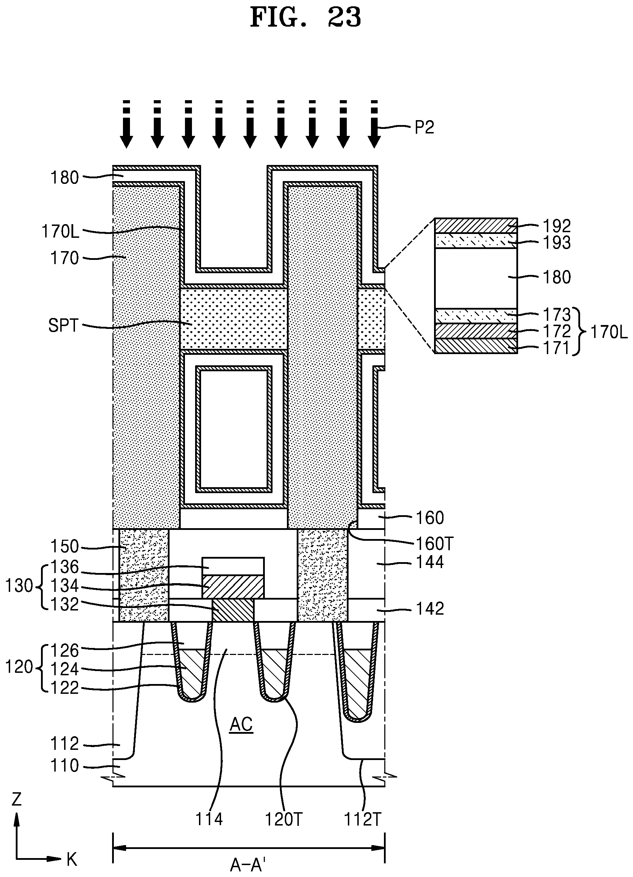

A nitrogen doping concentration in the second upper interface layer 192 may be higher than a nitrogen doping concentration in the first upper interface layer 191. In other words, the first upper interface layer 191 and the second upper interface layer 192 may be distinguished from each other by the difference in nitrogen doping concentration therebetween. A nitrogen doping concentration in the third upper interface layer 193 may be higher than a nitrogen doping concentration in the capacitor dielectric film 180 facing the third upper interface layer 193. In other words, the third upper interface layer 193 and the capacitor dielectric film 180 may be distinguished from each other by the difference in nitrogen doping concentration therebetween. According to the characteristics of manufacturing processes, doping of nitrogen included in the second upper interface layer 192 and doping of nitrogen included in the third upper interface layer 193 may be simultaneously performed by a single second heat treatment (P2 in FIG. 23), which is described below.

With the recent rapid development of miniaturized semiconductor process technology, the high integration density of the integrated circuit device 10 has been accelerated, and the area of each cell has decreased. Accordingly, an area that may be occupied by a capacitor structure CS in each cell has also decreased. For example, with the increase in the integration density of the integrated circuit device 10, such as dynamic random-access memory (DRAM), the area of each cell has decreased while necessary capacitance has been maintained or increased.

Therefore, in the capacitor structure CS in which neighboring lower electrodes 170 are very close to each other and neighboring upper electrodes 190 are very close to each other because of the decrease in the area of each cell, leakage current may undesirably flow through the capacitor dielectric film 180. Moreover, a high-k material, such as zirconium oxide, hafnium oxide, or aluminum oxide, may be used for the capacitor dielectric film 180 which has characteristics of high capacitance and high bandgap but may cause leakage current to increase because of a relatively high oxygen vacancy concentration. In other words, what is needed is a structure for maintaining desired electrical characteristics by overcoming the spatial limit of the integrated circuit device 10 having a high integration density and the limit of design rules and increasing the capacitance of the integrated circuit device 10.

According to the inventive concepts, to reduce leakage current involved in the oxygen vacancy in the capacitor dielectric film 180, the lower interface film 170L doped with nitrogen is arranged between the lower electrode 170 and the capacitor dielectric film 180 and the upper interface film 190L doped with nitrogen is arranged between the upper electrode 190 and the capacitor dielectric film 180 in the integrated circuit device 10.

After a material constituting the lower interface film 170L and a material constituting the upper interface film 190L are formed, nitrogen may be diffused as a dopant from a process gas (e.g., ammonia gas or nitrogen gas) into the lower interface film 170L and the upper interface film 190L through first and second heat treatments so that a portion of the lower interface film 170L and a portion of the upper interface film 190L may be doped with nitrogen. It is expected that, when each of the lower interface film 170L and the upper interface film 190L is formed in a multi-layer structure having different nitrogen concentrations in the manner described above, a trap caused by an oxygen vacancy in the capacitor dielectric film 180 may be significantly removed by nitrogen. According to experimental examples described below, it is seen that the presence of the lower interface film 170L and the upper interface film 190L may more efficiently prevent or reduce leakage current from occurring in the capacitor dielectric film 180.

Eventually, leakage current flowing through the capacitor dielectric film 180 between neighboring capacitor structures CS may be reduced in the integrated circuit device 10 by including the lower interface film 170L and the upper interface film 190L, each having a multi-layer structure having different nitrogen doping concentrations, in each of the capacitor structures CS.

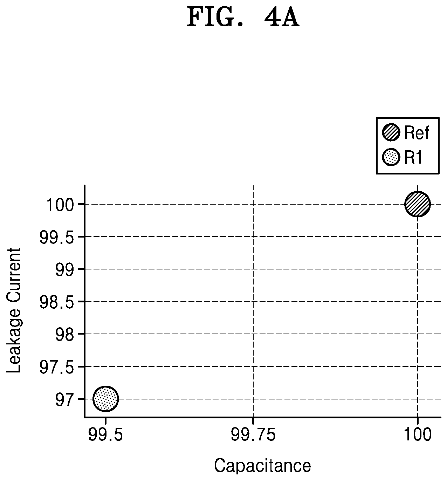

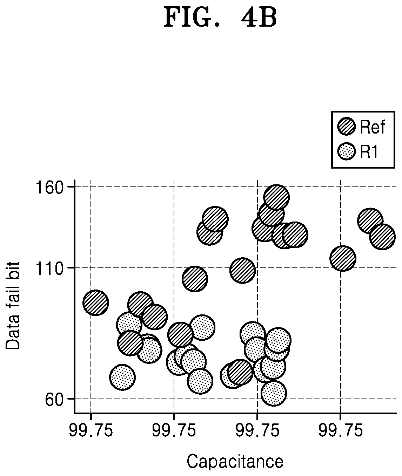

FIGS. 4A and 4B are graphs showing the change in electrical characteristics according to the presence or absence of an upper interface film in an integrated circuit device, according to various example embodiments.

In detail, FIG. 4A is a graph showing a comparison of leakage current in a first experimental example R1 including an upper interface film of the inventive concepts with leakage current in a comparative example Ref. FIG. 4B is a graph showing a comparison of data fail bits in the first experimental example R1 including the upper interface film of the inventive concepts with data fail bits in the comparative example Ref.

FIG. 4A shows the change in leakage current characteristics according to presence or absence of the upper interface film 190L (see FIG. 3) in the first experimental example R1 and the comparative example Ref. Referring to FIG. 4A, through the comparison between the first experimental example R1 and the comparative example Ref, it is seen that the capacitance (the horizontal axis) of the capacitor dielectric film 180 (see FIG. 3) having thereon the upper interface film 190L (FIG. 3) is similar while leakage current (the vertical axis) therein is relative low.

FIG. 4B shows the change in data fail bit characteristics according to presence or absence of the upper interface film 190L (FIG. 3) in the first experimental example R1 and the comparative example Ref. Referring to FIG. 4B, through the comparison between the first experimental example R1 and the comparative example Ref, it is seen that the capacitance (the horizontal axis) of the capacitor dielectric film 180 (FIG. 3) having thereon the upper interface film 190L (FIG. 3) is similar while data fail bits (the vertical axis) show a relative decreasing trend (about 1.3 times improvement).

In other words, it is proved that leakage current flowing through the capacitor dielectric film 180 (FIG. 3) is reduced by removing a trap occurring due to an oxygen vacancy in the capacitor dielectric film 180 by using the upper interface film 190L (FIG. 3) having a multi-layer structure having different nitrogen doping concentrations. It is also seen that the electrical characteristics of an integrated circuit device of the inventive concept are improved.

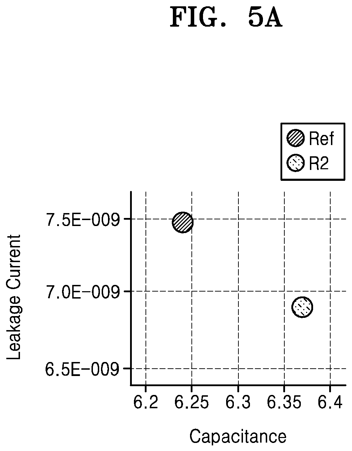

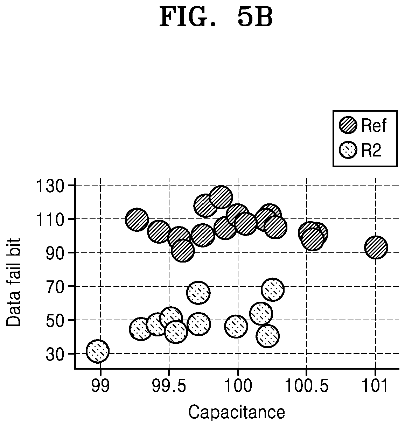

FIGS. 5A and 5B are graphs showing the change in electrical characteristics according to the presence or absence of a lower interface film in an integrated circuit device, according to various example embodiments.

In detail, FIG. 5A is a graph showing a comparison of leakage current in a second experimental example R2 including a lower interface film of the inventive concepts with leakage current in the comparative example Ref. FIG. 5B is a graph showing a comparison of data fail bits in the second experimental example R2 including the lower interface film of the inventive concepts with data fail bits in the comparative example Ref.

FIG. 5A shows the change in leakage current characteristics according to presence or absence of the lower interface film 170L (see FIG. 3) in the second experimental example R2 and the comparative example Ref. Referring to FIG. 5A, through the comparison between the second experimental example R2 and the comparative example Ref, it is seen that the capacitance (the horizontal axis) of the capacitor dielectric film 180 (see FIG. 3) having thereunder the lower interface film 170L (FIG. 3) is relatively high while leakage current (the vertical axis) therein is relative low.

FIG. 5B shows the change in data fail bit characteristics according to presence or absence of the lower interface film 170L (FIG. 3) in the second experimental example R2 and the comparative example Ref. Referring to FIG. 5B, through the comparison between the second experimental example R2 and the comparative example Ref, it is seen that the capacitance (the horizontal axis) of the capacitor dielectric film 180 (FIG. 3) having thereunder the lower interface film 170L (FIG. 3) is similar while data fail bits (the vertical axis) show a relative decreasing trend (about 2.3 times improvement).

In other words, it is proved that leakage current flowing through the capacitor dielectric film 180 (FIG. 3) is reduced by removing a trap occurring due to an oxygen vacancy in the capacitor dielectric film 180 by using the lower interface film 170L (FIG. 3) having a multi-layer structure having different nitrogen doping concentrations. It is also seen that the electrical characteristics of an integrated circuit device of the inventive concept are improved.

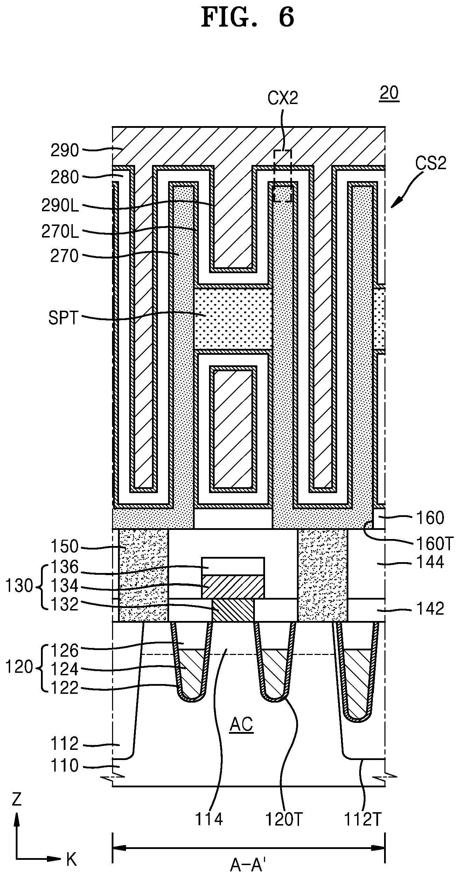

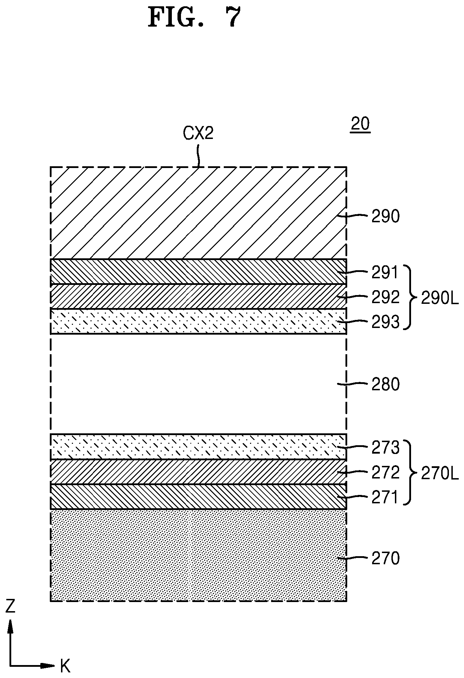

FIGS. 6 and 7 are cross-sectional views of an integrated circuit device 20 according to embodiments. In detail, FIG. 6 is a cross-sectional view taken along the line A-A' in FIG. 1 and FIG. 7 is an enlarged view of a region CX2 in FIG. 6.

The elements of the integrated circuit device 20 and the materials of the elements described below are mostly and substantially the same as or similar to those described above with reference to FIGS. 1 to 3. For convenience of description, therefore, the integrated circuit device 20 is described focusing on the differences from the integrated circuit device 10.

Referring to FIGS. 6 and 7, the integrated circuit device 20 includes a lower electrode 270 above the substrate 110, a supporter SPT supporting the lower electrode 270, a capacitor dielectric film 280 on the lower electrode 270, and an upper electrode 290 on the capacitor dielectric film 280.

The lower electrode 270 of the integrated circuit device 20 may have a cylindrical or cup shape with a closed bottom on the contact structure 150.

A capacitor structure CS2 includes the lower electrode 270 electrically connected to the contact structure 150, the capacitor dielectric film 280 conformally covering the lower electrode 270, and the upper electrode 290 on the capacitor dielectric film 280.

When the lower electrode 270 has a cylindrical shape, the surface area of the lower electrode 270 corresponding to a storage electrode may be maximized, and accordingly, the capacitance of the capacitor structure CS2 may increase.

In the integrated circuit device 20 of the inventive concept, a lower interface film 270L is between the lower electrode 270 and the capacitor dielectric film 280 and an upper interface film 290L is between the upper electrode 290 and the capacitor dielectric film 280.

The lower interface film 270L is described first below. The lower interface film 270L has a three-layer structure of a first lower interface layer 271, a second lower interface layer 272, and a third lower interface layer 273. In detail, the lower interface film 270L includes a structure, in which the first lower interface layer 271, the second lower interface layer 272, and the third lower interface layer 273 are sequentially stacked on the lower electrode 270, wherein the first lower interface layer 271 includes metal oxide doped with an impurity, the second lower interface layer 272 includes a material that is identical to the material of the first lower interface layer 271 and doped with nitrogen, and the third lower interface layer 273 includes a material that is identical to the material of the capacitor dielectric film 280 and doped with nitrogen.

The upper interface film 290L is described below. The upper interface film 290L has a three-layer structure of a first upper interface layer 291, a second upper interface layer 292, and a third upper interface layer 293. In detail, the upper interface film 290L includes a structure, in which the first upper interface layer 291, the second upper interface layer 292, and the third upper interface layer 293 are sequentially stacked on the upper electrode 290, wherein the first upper interface layer 291 includes metal oxide, the second upper interface layer 292 includes a material that is identical to the material of the first upper interface layer 291 and doped with nitrogen, and the third upper interface layer 293 includes a material that is identical to the material of the capacitor dielectric film 280 and doped with nitrogen.

The descriptions of the lower electrode 270, the capacitor dielectric film 280, and the upper electrode 290 are the same as those of the lower electrode 170, the capacitor dielectric film 180, and the upper electrode 190 described above with reference to FIGS. 1 to 3. The descriptions of the lower interface film 270L between the lower electrode 270 and the capacitor dielectric film 280 and the upper interface film 290L between the upper electrode 290 and the capacitor dielectric film 280 are also the same as those of the lower interface film 170L and the upper interface film 190L described above with reference to FIGS. 1 to 3. Therefore, the detailed descriptions thereof are omitted.

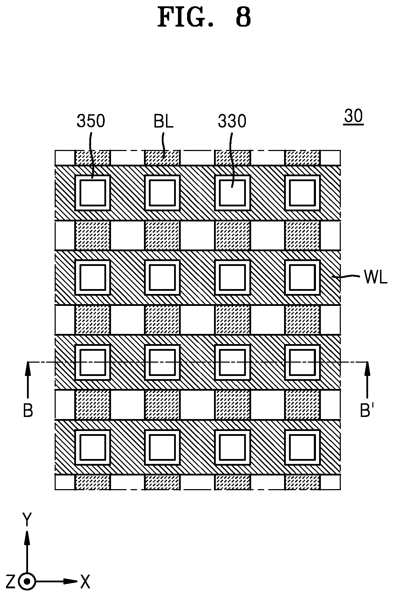

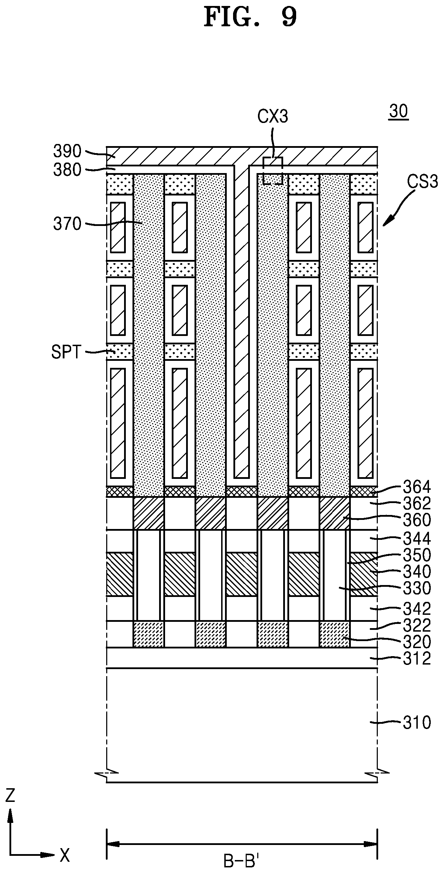

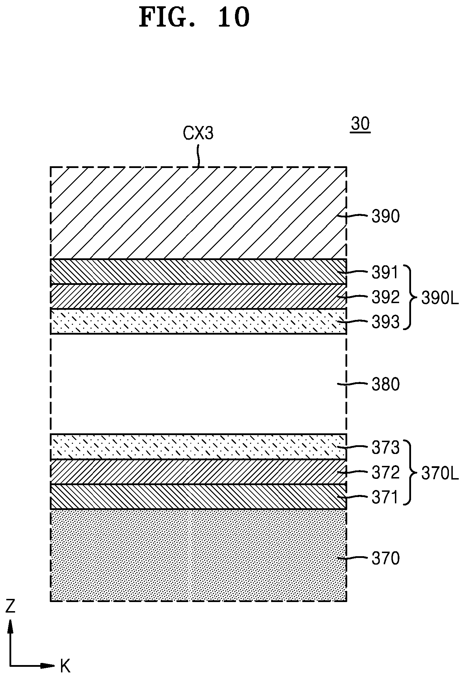

FIGS. 8 to 10 are cross-sectional views of an integrated circuit device according to various example embodiments. In detail, FIG. 8 is a layout diagram of an integrated circuit device 30 according to some embodiments. FIG. 9 is a cross-sectional view of the integrated circuit device 30, taken along line B-B' in FIG. 8. FIG. 10 is an enlarged view of a region CX3 in FIG. 9.

The elements of the integrated circuit device 30 and the materials of the elements described below are mostly and substantially the same as or similar to those described above with reference to FIGS. 1 to 3. For convenience of description, therefore, the integrated circuit device 30 is described focusing on the differences from the integrated circuit device 10.

Referring to FIGS. 8 to 10, the integrated circuit device 30 includes a capacitor structure CS3 on a vertical channel transistor (VCT) structure.

A lower insulating layer 312 may be on a substrate 310. A plurality of first conductive lines 320 may extend in the Y direction on the lower insulating layer 312 and may be apart from each other in the X direction. A plurality of first insulating patterns 322 may be on the lower insulating layer 312 and may respectively fill the spaces among the first conductive lines 320. The first conductive lines 320 may respectively correspond to bit lines BL of the integrated circuit device 30.

In some embodiments, the first conductive lines 320 may include doped polysilicon, metal, conductive metal nitride, conductive metal silicide, conductive metal oxide, or a combination thereof. For example, the first conductive lines 320 may include, but not limited to, doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrO, RuO, or a combination thereof. However, example embodiments are not limited thereto. The first conductive lines 320 may include a single- or multi-layer of the above materials. In some embodiments, the first conductive lines 320 may include a two-dimensional (2D) semiconductor material. For example, the 2D semiconductor material may include graphene, carbon nanotube, or a combination thereof.

A plurality of channel layers 330 may be arranged on the first conductive lines 320 and may have island shapes, which are apart from one another in the X direction and the Y direction. Each of the channel layers 330 may have a channel width in the X direction and a channel height in the Z direction, wherein the channel height may be greater than the channel width. A bottom portion of each channel layer 330 may function as a first source/drain region (not shown) and an upper portion of the channel layer 330 may function as a second source/drain region (not shown). A portion of the channel layer 330 between the first and second source/drain regions may function as a channel region (not shown). A VCT may refer to a structure, in which the channel length of the channel layer 330 extends in the Z direction from the substrate 310.

In some embodiments, the channel layer 330 may include an oxide semiconductor. For example, the oxide semiconductor may include InₓGa_{y}Zn_{z}O, InₓGa_{y}Si_{z}O, InₓSn_{y}Zn_{z}O, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, InₓGa_{y}O, or a combination thereof. However, example embodiments are not limited thereto. The channel layer 330 may include a single- or multi-layer structure of the oxide semiconductor. In some embodiments, the channel layer 330 may have bandgap energy that is greater than the bandgap energy of silicon. The channel layer 330 may be polycrystalline or amorphous but is not limited thereto. In some embodiments, the channel layer 330 may include a 2D semiconductor material. For example, the 2D semiconductor material may include graphene, carbon nanotube, or a combination thereof.

In some embodiments, a gate electrode 340 may surround the sidewall of the channel layer 330 and extend in the X direction. The gate electrode 340 may be of a gate-all-around type surrounding all around the sidewall of the channel layer 330. The gate electrode 340 may correspond to a word line WL of the integrated circuit device 30.

In some embodiments, the gate electrode 340 may be of a dual-gate type. For example, the gate electrode 340 may include a first sub gate electrode (not shown), which faces a first sidewall of the channel layer 330, and a second sub gate electrode (not shown), which faces a second sidewall opposite to the first sidewall of the channel layer 330.

In some embodiments, the gate electrode 340 may be of a single-gate type and may extend in the X direction covering only the first sidewall of the channel layer 330.

The gate electrode 340 may include doped polysilicon, metal, conductive metal nitride, conductive metal silicide, conductive metal oxide, or a combination thereof. For example, the gate electrode 340 may include, but not limited to, doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof.

A gate insulating layer 350 may surround the sidewall of the channel layer 330 and may be between the channel layer 330 and the gate electrode 340. In some embodiments, the gate insulating layer 350 may include silicon nitride, silicon oxide, silicon oxynitride, a high-k material having a higher dielectric constant than silicon oxide, or a combination thereof. The high-k material may include metal oxide or metal oxynitride. For example, the high-k material of the gate insulating layer 350 may include, but not limited to, HfO₂, HfSiO, HfSiON, HfTaO, HfTiO, HfZrO, ZrO₂, Al₂O₃, or a combination thereof.

A first buried insulating layer 342 surrounding a lower sidewall of the channel layer 330 may be on the first insulating patterns 322. A second buried insulating layer 344 may be above the first buried insulating layer 342 and may surround an upper sidewall of the channel layer 330 and cover the gate electrode 340.

A capacitor contact 360 may be on the channel layer 330. The capacitor contact 360 may vertically overlap the channel layer 330. A plurality of capacitor contacts 360 may be arranged in a matrix to be apart from one another in the X direction and the Y direction. The capacitor contact 360 may include, but not limited to, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrO, RuO, or a combination thereof. An upper insulating layer 362 may be on the second buried insulating layer 344 and may surround the sidewall of the capacitor contact 360.

An etch stop film 364 may be on the upper insulating layer 362 and the capacitor structure CS3 may be on the etch stop film 364. The capacitor structure CS3 includes a lower electrode 370, a capacitor dielectric film 380, and an upper electrode 390. The lower electrode 370 may be electrically connected to the capacitor contact 360. The capacitor dielectric film 380 covers the lower electrode 370. The upper electrode 390 is on the capacitor dielectric film 380 and cover the lower electrode 370. A supporter SPT is on the sidewall of the lower electrode 370.

In the integrated circuit device 30 of the inventive concept, a lower interface film 370L is between the lower electrode 370 and the capacitor dielectric film 380 and an upper interface film 390L is between the upper electrode 390 and the capacitor dielectric film 380.

The lower interface film 370L is described first below. The lower interface film 370L has a three-layer structure of a first lower interface layer 371, a second lower interface layer 372, and a third lower interface layer 373. In detail, the lower interface film 370L includes a structure, in which the first lower interface layer 371, the second lower interface layer 372, and the third lower interface layer 373 are sequentially stacked on the lower electrode 370, wherein the first lower interface layer 371 includes metal oxide doped with an impurity, the second lower interface layer 372 includes a material that is identical to the material of the first lower interface layer 371 and doped with nitrogen, and the third lower interface layer 373 includes a material that is identical to the material of the capacitor dielectric film 380 and doped with nitrogen.

The upper interface film 390L is described below. The upper interface film 390L has a three-layer structure of a first upper interface layer 391, a second upper interface layer 392, and a third upper interface layer 393. In detail, the upper interface film 390L includes a structure, in which the first upper interface layer 391, the second upper interface layer 392, and the third upper interface layer 393 are sequentially stacked on the upper electrode 390, wherein the first upper interface layer 391 includes metal oxide, the second upper interface layer 392 includes a material that is identical to the material of the first upper interface layer 391 and doped with nitrogen, and the third upper interface layer 393 includes a material that is identical to the material of the capacitor dielectric film 380 and doped with nitrogen.

The descriptions of the lower electrode 370, the capacitor dielectric film 380, and the upper electrode 390 are the same as those of the lower electrode 170, the capacitor dielectric film 180, and the upper electrode 190 described above with reference to FIGS. 1 to 3. The descriptions of the lower interface film 370L between the lower electrode 370 and the capacitor dielectric film 380 and the upper interface film 390L between the upper electrode 390 and the capacitor dielectric film 380 are also the same as those of the lower interface film 170L and the upper interface film 190L described above with reference to FIGS. 1 to 3. Therefore, the detailed descriptions thereof are omitted.

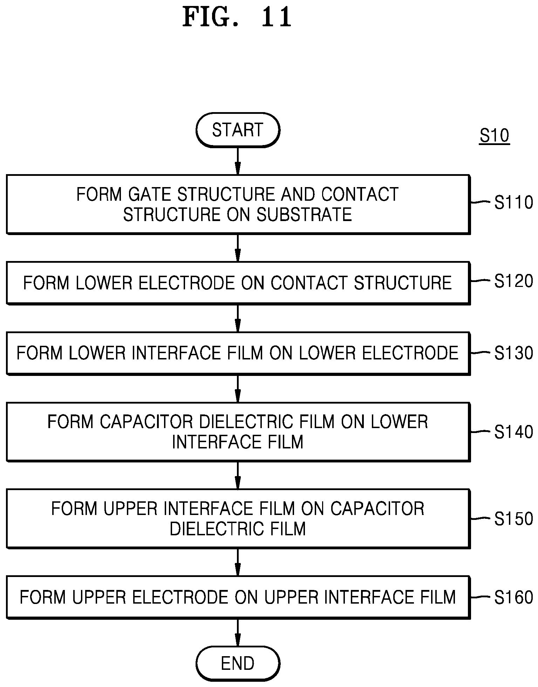

FIGS. 11 to 13 are flowcharts of a method of manufacturing an integrated circuit device, according to an embodiment.

When it is possible to modify an embodiment, the order of operations may be different from the order in which the operations are described. For instance, two operations described as being performed sequentially may be substantially performed simultaneously or in a reverse order.

Referring to FIG. 11, a method S10 of manufacturing an integrated circuit device may include the sequence of operations S110 to S160.

The method S10 may include forming a gate structure and a contact structure on a substrate in operation S110, forming a lower electrode on the contact structure in operation S120, forming a lower interface film on the lower electrode in operation S130, forming a capacitor dielectric film on the lower interface film in operation S140, forming an upper interface film on the capacitor dielectric film in operation S150, and forming an upper electrode on the upper interface film in operation S160.

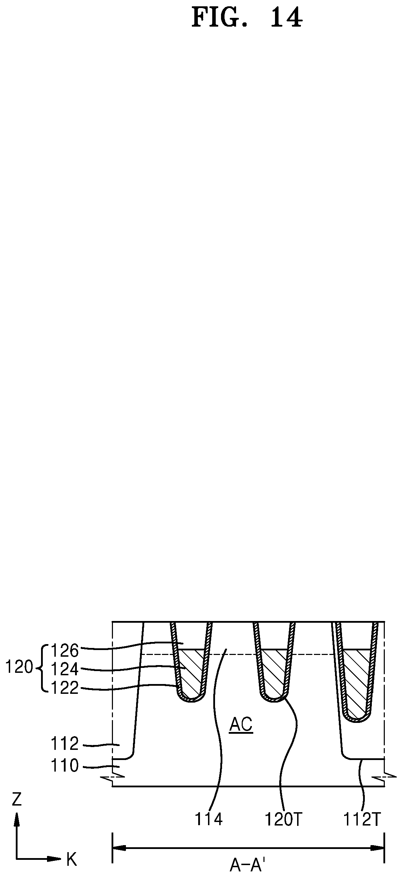

The technical characteristics of operations S110 to S160 are described in detail below with reference to FIGS. 14 to 24.

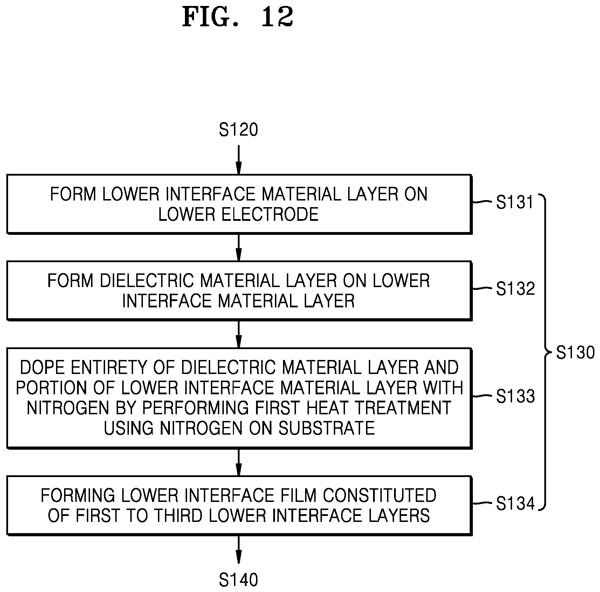

Referring to FIG. 12, operation S130 of forming the lower interface film in the method S10 may include sub operations S131 to S134.

In the method S10, operation S130 may include forming a lower interface material layer on the lower electrode in sub operation S131, forming a dielectric material layer on the lower interface material layer in sub operation S132, doping the entirety of the dielectric material layer and a portion of the lower interface material layer with nitrogen by performing a first heat treatment using nitrogen on the substrate in sub operation S133, and forming the lower interface film constituted of first to third lower interface layers in sub operation S134.

Here, the first heat treatment may include, but not limited to, a heat treatment using ammonia gas, a plasma heat treatment using nitrogen gas, or a plasma heat treatment using ammonia gas. However, example embodiments are not limited thereto.

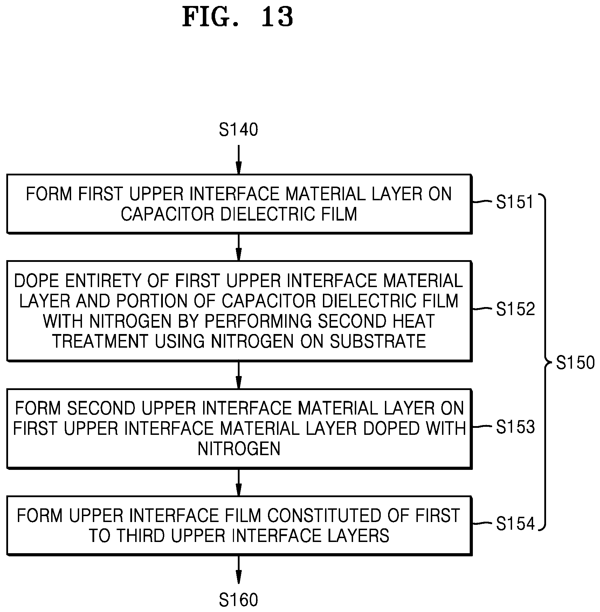

Referring to FIG. 13, operation S150 of forming the lower interface film in the method S10 may include sub operations S151 to S154.

In the method S10, operation S150 may include forming a first upper interface material layer on the capacitor dielectric film in sub operation S151, doping the entirety of the first upper interface material layer and a portion of the capacitor dielectric film with nitrogen by performing a second heat treatment using nitrogen on the substrate in sub operation S152, forming a second upper interface material layer on the first upper interface material layer doped with nitrogen in sub operation S153, and forming the upper interface film constituted of first to third upper interface layers in sub operation S154.

Here, the second heat treatment may include, but not limited to, a heat treatment using ammonia gas, a plasma heat treatment using nitrogen gas, or a plasma heat treatment using ammonia gas. However, example embodiments are not limited thereto.

FIGS. 14 to 24 are cross-sectional views of stages in a method of manufacturing an integrated circuit device, according to an embodiment.

For convenience of descriptions, FIGS. 14 to 24 are cross-sectional views taken along the line A-A' in FIG. 1.

Referring to FIG. 14, the isolation trench 112T may be formed in the substrate 110, and the isolation film 112 defining the active region AC may be formed in the isolation trench 112T.

Subsequently, a mask pattern (not shown) may be formed on the substrate 110, and a plurality of gate line trenches 120T may be formed in the substrate 110 by using the mask pattern as an etch mask. The gate line trenches 120T may extend in parallel with each other, and each of the gate line trenches 120T may have a line shape crossing the active region AC.

Subsequently, the gate insulating layer 122 may be formed on the inner wall of each of the gate line trenches 120T. The gate electrode layer 124 may be formed by forming a gate conductive layer (not shown) on the gate insulating layer 122 to fill each gate line trench 120T and then removing an upper portion of the gate conductive layer to a certain height using an etch back process.

Subsequently, the gate capping layer 126 may be formed in the gate line trench 120T by forming an insulating material to fill the remaining portion of the gate line trench 120T and planarizing the insulating material to expose the top surface of the substrate 110. At this time, the mask pattern may be removed.

Subsequently, the source/drain region 114 may be formed by implanting impurity ions into a portion of the substrate 110 at each of opposite sides of the gate structure 120. Alternatively, the source/drain region 114 may be formed on the active region AC by implanting impurity ions into the substrate 110 after the isolation film 112 is formed.

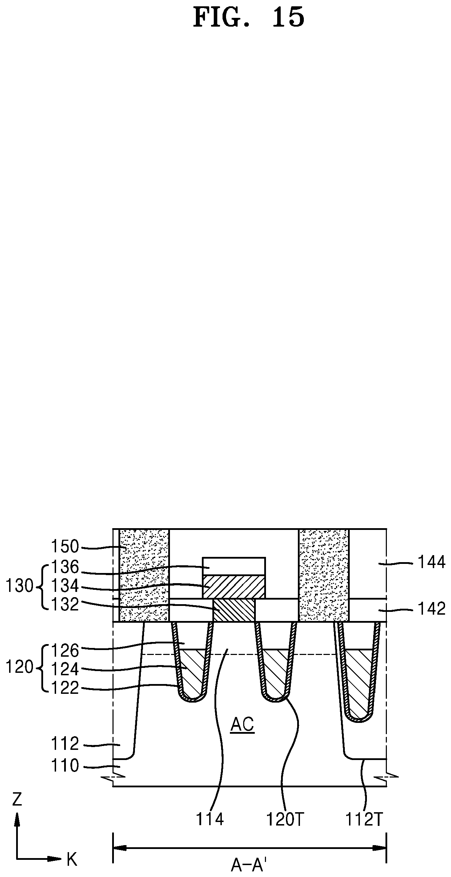

Referring to FIG. 15, the first interlayer insulating film 142 may be formed on the substrate 110, and an opening may be formed in the first interlayer insulating film 142 to expose a top surface of the source/drain region 114.

The bit line contact 132 electrically connected to the source/drain region 114 may be formed in the opening by forming a conductive layer on the first interlayer insulating film 142 to fill the opening and planarizing an upper portion of the conductive layer.

Subsequently, the bit line 134 and the bit line capping layer 136 may be formed to extend in the Y direction, which is parallel with the top surface of the substrate 110, by sequentially forming a conductive layer and an insulating layer on the first interlayer insulating film 142 and then patterning the conductive layer and the insulating layer. Although not shown, a bit line spacer may be further formed on the side walls of the bit line 134 and the bit line capping layer 136.

Subsequently, the second interlayer insulating film 144 may be formed on the first interlayer insulating film 142 to cover the bit line 134 and the bit line capping layer 136.

Subsequently, an opening may be formed in the first and second interlayer insulating films 142 and 144 to expose the top surface of the source/drain region 114, and a contact structure 150 may be formed in the opening of the first and second interlayer insulating films 142 and 144. In some example embodiments, the contact structure 150 may be formed by sequentially forming a lower contact (not shown), a metal silicide layer (not shown), and an upper contact (not shown) in the opening of the first and second interlayer insulating films 142 and 144.

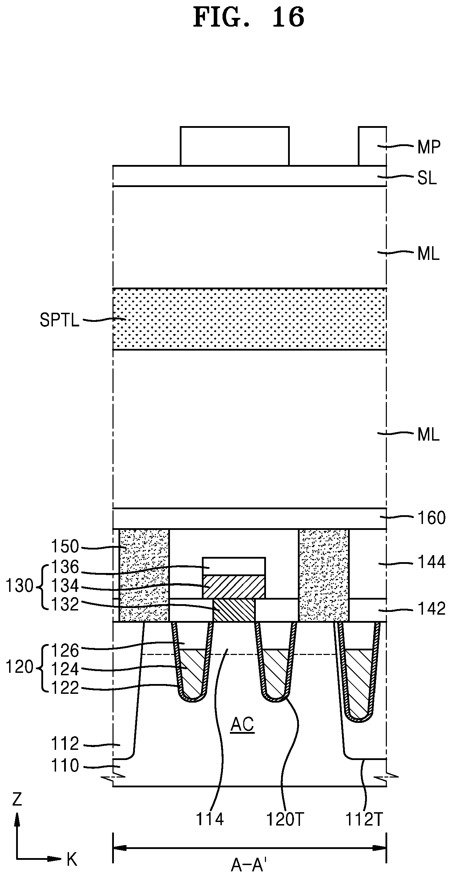

Referring to FIG. 16, the etch stop film 160, a mold layer ML, a supporter forming layer SPTL, and a sacrificial layer SL may be sequentially formed on the second interlayer insulating film 144 and the contact structure 150.

The mold layer ML may include silicon oxide. For example, the mold layer ML may be formed using a material, such as BPSG, spin on dielectric (SOD), PSG, PE-TEOS, or low pressure TEOS (LPTEOS). The mold layer ML may be formed to a thickness of about 500 nm to about 4000 nm but is not limited thereto.

Subsequently, the supporter forming layer SPTL may be formed in the mold layer ML. The supporter forming layer SPTL may include silicon oxide, silicon nitride, or silicon oxynitride.

Subsequently, the sacrificial layer SL may be formed on the mold layer ML. For example, the sacrificial layer SL may be formed using a material, such as TEOS, BPSG, PSG, USG, SOD, or high-density plasma oxide (HDP). The sacrificial layer SL may be formed to a thickness of about 50 nm to about 200 nm but is not limited thereto.

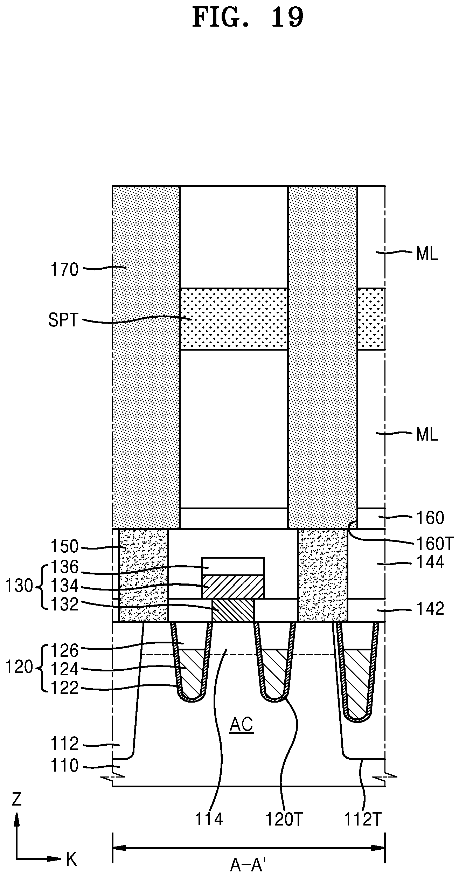

Subsequently, a mask pattern MP may be formed by applying photoresist to the sacrificial layer SL and patterning the photoresist through exposure and development. A region, in which the lower electrode 170 (see FIG. 19) is to be formed, may be defined by the mask pattern MP. An anti-reflective coating (ARC) (not shown) may also be formed on the sacrificial layer SL.

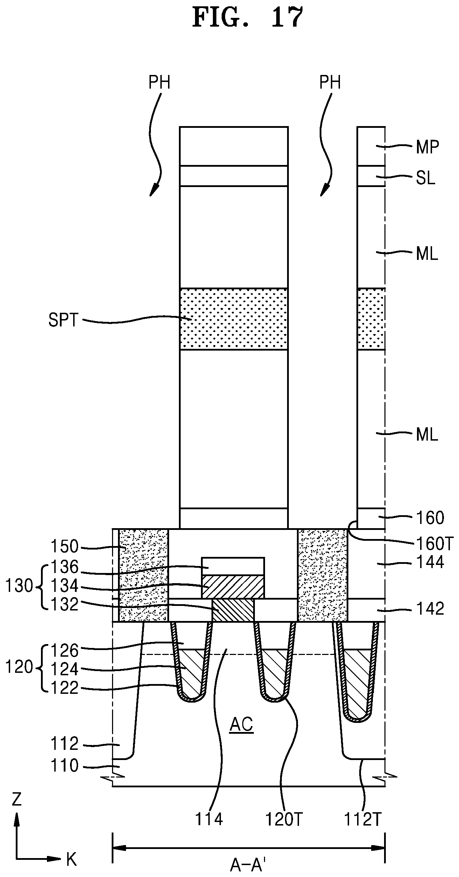

Referring to FIG. 17, a through hole PH may be formed by sequentially etching the sacrificial layer SL, the supporter forming layer SPTL, and the mold layer ML by using the mask pattern MP as an etch mask.

Subsequently, the opening 160T may be formed by removing a portion of the etch stop film 160, which is exposed at the bottom of the through hole PH. The top surface of the contact structure 150 may be exposed by the through hole PH and the opening 160T.

Subsequently, the mask pattern MP may be removed by ashing and stripping processes.

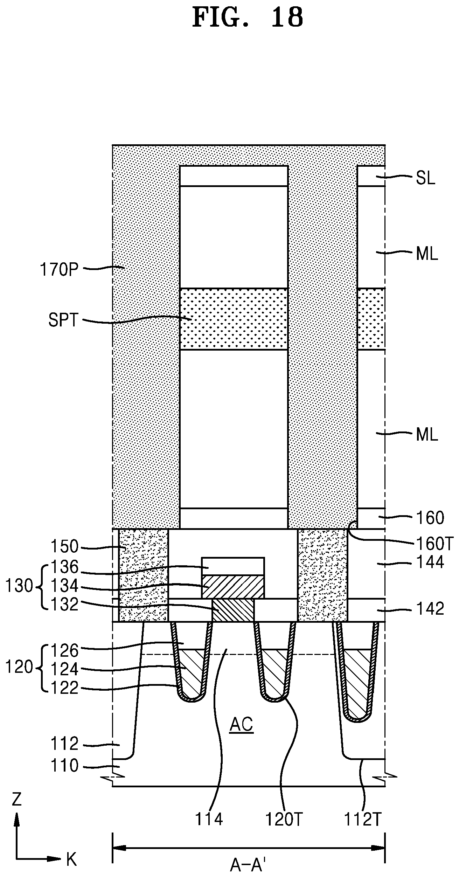

Referring to FIG. 18, a lower electrode forming layer 170P may be formed to conformally cover the inner walls of the through hole PH and the opening 160T.

In various example embodiments, the lower electrode forming layer 170P may be formed on the side surfaces of the etch stop film 160, the side surfaces of the mold layer ML, the side surfaces of the supporter forming layer SPTL, and the side and top surfaces of the sacrificial layer SL so as to be in contact with the top surface of the contact structure 150. For example, the lower electrode forming layer 170P may be formed using CVD or ALD.

Referring to FIG. 19, the lower electrode 170 may be formed by removing a portion of the lower electrode forming layer 170P (see FIG. 18), which is above the top surface of the mold layer ML, and the sacrificial layer SL (see FIG. 18) using a node separation process.

The node separation process may remove the sacrificial layer SL through an etch back process or chemical mechanical polishing (CMP).

Subsequently, the mold layer ML may be removed. For example, when the mold layer ML includes silicon oxide, the mold layer ML may be completely removed by a wet etching process using hydrofluoric acid or buffered oxide etchant (BOE).

During the wet etching process, the supporter SPT may not be etched but remain and firmly support the lower electrode 170, thereby preventing the lower electrode 170 from collapsing or breaking. The lower electrode 170 may be formed on the contact structure 150 to have a pillar shape extending in the Z direction that is perpendicular to the top surface of the substrate 110.

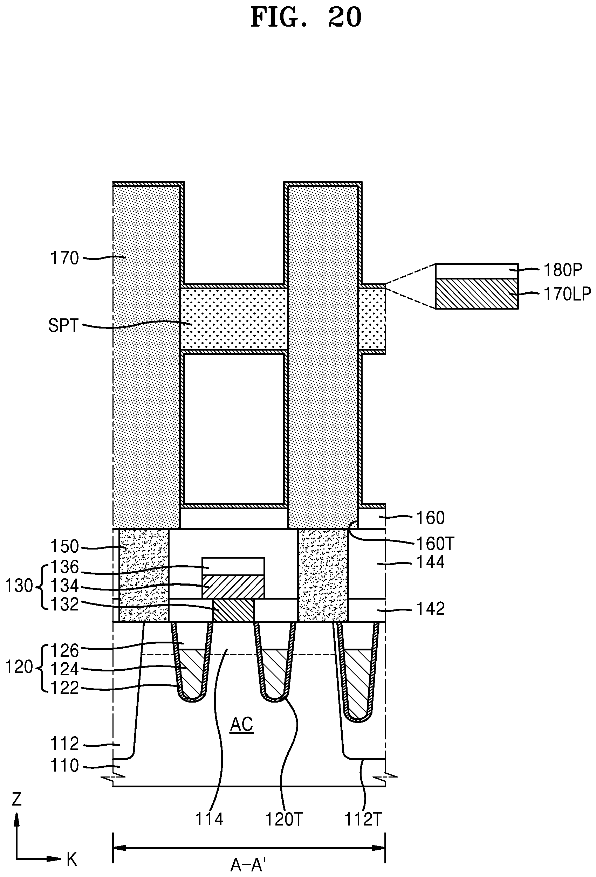

Referring to FIG. 20, a lower interface material layer 170LP may be formed on the outer surfaces of the lower electrode 170 and the supporter SPT and a dielectric material layer 180P may be formed on the lower interface material layer 170LP.

The lower interface material layer 170LP may first be formed on the outer surfaces of the lower electrode 170 and the supporter SPT. The lower interface material layer 170LP may include metal oxide doped with an impurity. In detail, the metal oxide included in the lower interface material layer 170LP may include titanium oxide and the impurity included in the lower interface material layer 170LP may include a pentad. For example, the impurity included in the lower interface material layer 170LP may include, but not limited to, vanadium (V), niobium (Nb), tantalum (Ta), phosphorus (P), or antimony (Sb).

Subsequently, the dielectric material layer 180P may be formed on the lower interface material layer 170LP. The dielectric material layer 180P may include at least one selected from the group consisting of zirconium oxide, hafnium oxide, and aluminum oxide. The thickness of the dielectric material layer 180P may be 10 angstroms but is not limited thereto.

Referring to FIG. 21, the first heat treatment P1 may be performed on the substrate 110 having formed thereon the lower interface material layer 170LP (see FIG. 20) and the dielectric material layer 180P (see FIG. 20).

In some embodiments, the first heat treatment P1 may be performed at a temperature of about 300°C to about 500°C for several minutes to several hours. In some cases, the first heat treatment P1 may be accompanied by a plasma treatment. The first heat treatment P1 is not limited to these numerical values. During the first heat treatment P1, nitrogen included in a process gas (ammonia gas or nitrogen gas) may be diffused as a dopant into the entirety of the dielectric material layer 180P (see FIG. 20) and an upper portion of the lower interface material layer 170LP (see FIG. 20).

Accordingly, a portion (e.g., a lower portion) of the lower interface material layer 170LP, which is not doped with nitrogen, may be formed as the first lower interface layer 171. The portion (e.g., the upper portion) of the lower interface material layer 170LP, which is doped with nitrogen, may be formed as the second lower interface layer 172. The dielectric material layer 180P doped with nitrogen may be formed as the third lower interface layer 173. In other words, the first lower interface layer 171 and the second lower interface layer 172 may be distinguished from each other by the difference in nitrogen doping concentration therebetween.

Through this process, the lower interface film 170L including the first to third lower interface layers 171, 172, and 173 may be formed on the lower electrode 170.

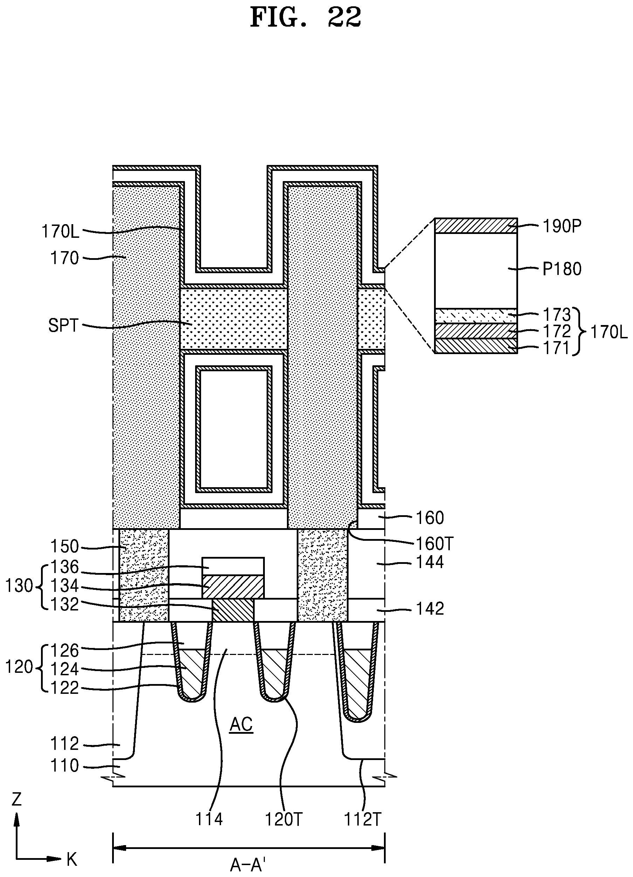

Referring to FIG. 22, a preliminary capacitor dielectric film P180 may be formed on the lower interface film 170L and an upper interface material layer 190P may be formed on the preliminary capacitor dielectric film P180.

The preliminary capacitor dielectric film P180 may first be formed on the outer surface of the preliminary capacitor dielectric film P180. The preliminary capacitor dielectric film P180 may include at least one selected from the group consisting of zirconium oxide, hafnium oxide, and aluminum oxide. The thickness of the preliminary capacitor dielectric film P180 may be 40 angstroms but is not limited thereto.

Subsequently, the upper interface material layer 190P may be formed on the upper interface material layer 190P. The upper interface material layer 190P may include metal oxide. In detail, the metal oxide included in the upper interface material layer 190P may include, but not limited to, titanium oxide, tantalum oxide, or niobium oxide. Unlike the lower interface material layer 170LP (see FIG. 20), the upper interface material layer 190P may not include a pentad as an impurity.

Referring to FIG. 23, the second heat treatment P2 may be performed on the substrate 110 having formed thereon the upper interface material layer 190P (see FIG. 22) and the preliminary capacitor dielectric film P180 (see FIG. 22).

In some embodiments, the second heat treatment P2 may be performed at a temperature of about 300°C to about 500°C for several minutes to several hours. In some cases, the second heat treatment P2 may be accompanied by a plasma treatment. The second heat treatment P2 is not limited to these numerical values. During the second heat treatment P2, nitrogen included in a process gas (ammonia gas or nitrogen gas) may be diffused as a dopant into the entirety of the upper interface material layer 190P (see FIG. 22) and an upper portion of the preliminary capacitor dielectric film P180 (see FIG. 22).

Accordingly, a portion (e.g., a lower portion) of the preliminary capacitor dielectric film P180, which is not doped with nitrogen, may be formed as the capacitor dielectric film 180. The portion (e.g., the upper portion) of the preliminary capacitor dielectric film P180, which is doped with nitrogen, may be formed as the third upper interface layer 193. The upper interface material layer 190P doped with nitrogen may be formed as the second upper interface layer 192.

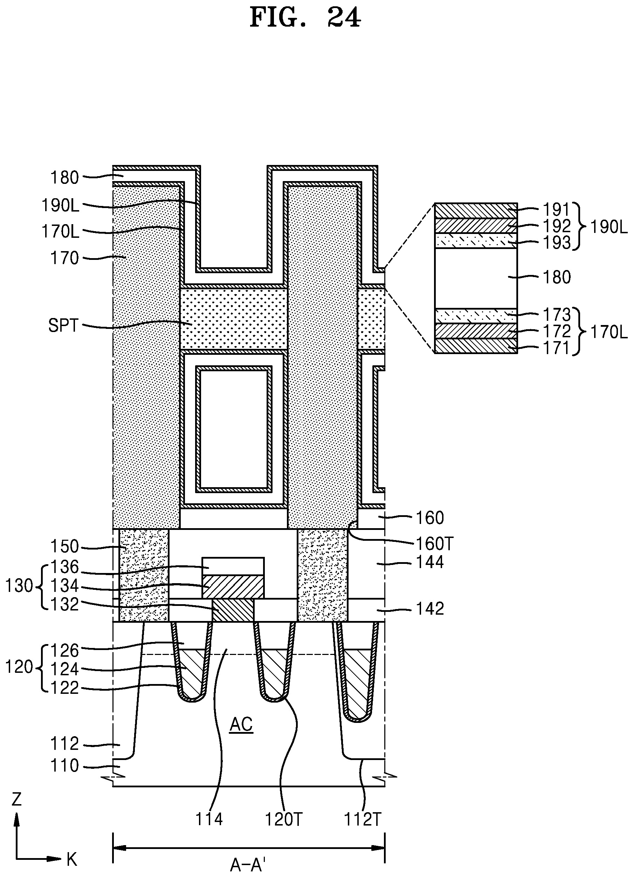

Referring to FIG. 24, the first upper interface layer 191 may be formed on the second upper interface layer 192.

The first upper interface layer 191 may include metal oxide. In detail, the metal oxide included in the first upper interface layer 191 may include, but not limited to, titanium oxide, tantalum oxide, or niobium oxide. In other words, the first upper interface layer 191 and the second upper interface layer 192 may be distinguished from each other by the difference in nitrogen doping concentration therebetween.

Through this process, the upper interface film 190L including the first to third upper interface layers 191, 192, and 193 may be formed on the capacitor dielectric film 180.

Referring back to FIG. 2, the upper electrode 190 may be formed on the upper interface film 190L.

The upper electrode 190 may be formed on the capacitor dielectric film 180 so as to completely fill the space defined by neighboring lower electrodes 170. The upper electrode 190 may be conformally formed on the capacitor dielectric film 180 to cover each lower electrode 170 with the capacitor dielectric film 180 between the upper electrode 190 and the lower electrode 170.

In some embodiments, the upper electrode 190 may include metal nitride, metal, or a combination thereof. For example, the upper electrode 190 may include at least one selected from the group consisting of TiN, TaN, WN, Ru, Pt, and Ir.

The integrated circuit device 10 may be completely formed by sequentially performing the processes described above.

Leakage current flowing through the capacitor dielectric film 180 between neighboring capacitor structures CS may be reduced in the integrated circuit device 10 by including the lower interface film 170L and the upper interface film 190L, each having a multi-layer structure having different nitrogen doping concentrations, in each of the capacitor structures CS.

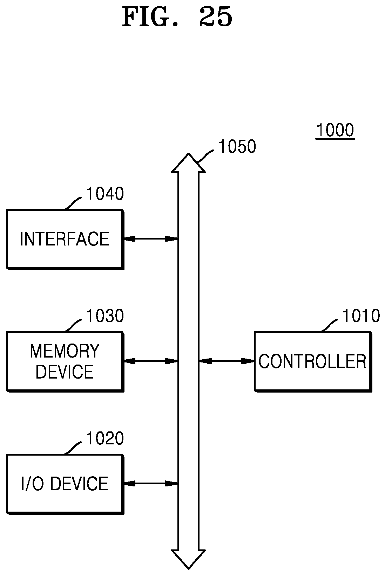

FIG. 25 is a block diagram of a system 1000 including an integrated circuit device, according to an embodiment.

Referring to FIG. 25, the system 1000 may include a controller 1010, an input/output (I/O) device 1020, a memory device 1030, an interface 1040, and a bus 1050.

The system 1000 may include a mobile system or a system transmitting or receiving information. In some embodiments, the mobile system may include a portable computer, a web tablet, a mobile phone, a digital music player, or a memory card.

The controller 1010 may control an executable program in the system 1000 and include a microprocessor, a digital signal processor, a microcontroller, or the like.

The I/O device 1020 may be used for data input or output of the system 1000. The system 1000 may connect to and exchange data with an external device, e.g., a personal computer (PC) or a network, using the I/O device 1020. For example, the I/O device 1020 may include a touch screen, a touch pad, a keyboard, or a display.

The memory device 1030 may store data for the operation of the controller 1010 or data that has been processed by the controller 1010. The memory device 1030 may include the integrated circuit device 10, 20, or 30 described above according to the inventive concepts.

The interface 1040 may correspond to a data transmission passage between the system 1000 and an external device. The controller 1010, the I/O device 1020, the memory device 1030, and the interface 1040 may communicate with one another through the bus 1050.

## Claims

1. A capacitor structure (CS) comprising:
a plurality of lower electrodes (170) on a substrate (110);
a supporter (SPT) between the plurality of lower electrodes (170);
an upper electrode (190) on the plurality of lower electrodes (170);
a capacitor dielectric film (180) between the plurality of lower electrodes (170) and the upper electrode (190);
a lower interface film (170L) between the plurality of lower electrodes (170) and the capacitor dielectric film (180), the lower interface film (170L) having a multi-layer structure having different nitrogen doping concentrations; and
an upper interface film (190L) between the upper electrode (190) and the capacitor dielectric film (180), the upper interface film (190L) having a multi-layer structure having different nitrogen doping concentrations, and
wherein the lower interface film (170L) includes
a first lower interface layer (171) including metal oxide doped with an impurity,
a second lower interface layer (172) including a material that is identical to a material of the first lower interface layer (171) and doped with nitrogen, and
a third lower interface layer (173) including a material that is identical to a material of the capacitor dielectric film (180) and doped with nitrogen, the first to third lower interface layers (171-173) being sequentially stacked on the plurality of lower electrodes (170), and
wherein the upper interface film (190L) includes
a first upper interface layer (191) including metal oxide,
a second upper interface layer (192) including a material that is identical to a material of the first upper interface layer (191) and doped with nitrogen, and
a third upper interface layer (193) including a material that is identical to the material of the capacitor dielectric film (180) and doped with nitrogen, the first to third upper interface layers (191-193) being sequentially stacked on the upper electrode (190), and
wherein the metal oxide included in the first lower interface layer (171) includes titanium oxide,
the impurity included in the first lower interface layer (171) includes a pentad, and
a nitrogen doping concentration in the second lower interface layer (172) is higher than a nitrogen doping concentration in the first lower interface layer (171).

2. The capacitor structure (CS) of claim 1, wherein the impurity included in the first lower interface layer (171) includes at least one of vanadium, V, niobium, Nb, tantalum, Ta, phosphorus, P, and antimony, Sb.

3. The capacitor structure (CS) of any one of claims 1 to 2, wherein the metal oxide included in the first upper interface layer (191) includes at least one of titanium oxide, tantalum oxide, and niobium oxide.

4. The capacitor structure (CS) of any one of claims 1 to 3, wherein a nitrogen doping concentration in the second upper interface layer (192) is higher than a nitrogen doping concentration in the first upper interface layer (191).

5. The capacitor structure (CS) of any one of claims 1 to 4, wherein the capacitor dielectric film (180) includes at least one selected from the group consisting of zirconium oxide, hafnium oxide, and aluminum oxide.

6. The capacitor structure (CS) of any one of claims 1 to 5, wherein a nitrogen doping concentration in each of the third lower interface layer (173) and the third upper interface layer (193) is higher than a nitrogen doping concentration in the capacitor dielectric film (180).

7. An integrated circuit device (10) comprising:
the capacitor structure (CS) according to any of claims 1 to 6 electrically connected to a transistor on the substrate (110).

## Patentansprüche

1. Kondensatorstruktur (CS), aufweisend:
eine Vielzahl von unteren Elektroden (170) auf einem Substrat (110);
einen Träger (SPT) zwischen der Vielzahl von unteren Elektroden (170);
eine obere Elektrode (190) auf der Vielzahl von unteren Elektroden (170);
einen dielektrischen Kondensatorfilm (180) zwischen der Vielzahl von unteren Elektroden (170) und der oberen Elektrode (190);
einen unteren Grenzflächenfilm (170L) zwischen der Vielzahl von unteren Elektroden (170) und dem dielektrischen Kondensatorfilm (180), wobei der untere Grenzflächenfilm (170L) eine Mehrschichtstruktur mit unterschiedlichen Stickstoffdotierungskonzentrationen aufweist; und
einen oberen Grenzflächenfilm (190L) zwischen der oberen Elektrode (190) und dem dielektrischen Kondensatorfilm (180), wobei der obere Grenzflächenfilm (190L) eine Mehrschichtstruktur mit unterschiedlichen Stickstoffdotierungskonzentrationen aufweist, und
wobei der untere Grenzflächenfilm (170L) umfasst
eine erste untere Grenzflächenschicht (171), die mit einer Verunreinigung dotiertes Metalloxid enthält,
eine zweite untere Grenzflächenschicht (172), die ein Material enthält, das mit einem Material der ersten unteren Grenzflächenschicht (171) identisch und mit Stickstoff dotiert ist, und
eine dritte untere Grenzflächenschicht (173), die ein Material enthält, das mit einem Material des dielektrischen Kondensatorfilms (180) identisch und mit Stickstoff dotiert ist, wobei die ersten bis dritten unteren Grenzflächenschichten (171-173) nacheinander auf der Vielzahl von unteren Elektroden (170) gestapelt sind, und
wobei der obere Grenzflächenfilm (190L) Folgendes umfasst:
eine erste obere Grenzflächenschicht (191), die Metalloxid enthält,
eine zweite obere Grenzflächenschicht (192), die ein Material enthält, das mit einem Material der ersten oberen Grenzflächenschicht (191) identisch und mit Stickstoff dotiert ist, und
eine dritte obere Grenzflächenschicht (193), die ein Material enthält, das mit dem Material des dielektrischen Kondensatorfilms (180) identisch und mit Stickstoff dotiert ist, wobei die ersten bis dritten oberen Grenzflächenschichten (191-193) nacheinander auf der oberen Elektrode (190) gestapelt sind, und
wobei das in der ersten unteren Grenzflächenschicht (171) enthaltene Metalloxid Titanoxid enthält,
die in der ersten unteren Grenzflächenschicht (171) enthaltene Verunreinigung eine Pentade umfasst, und
eine Stickstoffdotierungskonzentration in der zweiten unteren Grenzflächenschicht (172) höher ist als eine Stickstoffdotierungskonzentration in der ersten unteren Grenzflächenschicht (171).

2. Kondensatorstruktur (CS) nach Anspruch 1, wobei die in der ersten unteren Grenzflächenschicht (171) enthaltene Verunreinigung mindestens eines von Vanadium (V), Niob (Nb), Tantal (Ta), Phosphor (P) und/oder Antimon (Sb) beinhaltet.

3. Kondensatorstruktur (CS) nach einem der Ansprüche 1 bis 2, wobei das in der ersten oberen Grenzflächenschicht (191) enthaltene Metalloxid mindestens eines von Titanoxid, Tantaloxid und/oder Nioboxid beinhaltet.

4. Kondensatorstruktur (CS) nach einem der Ansprüche 1 bis 3, wobei eine Stickstoffdotierungskonzentration in der zweiten oberen Grenzflächenschicht (192) höher ist als eine Stickstoffdotierungskonzentration in der ersten oberen Grenzflächenschicht (191).

5. Kondensatorstruktur (CS) nach einem der Ansprüche 1 bis 4, wobei der dielektrische Kondensatorfilm (180) aus der Gruppe bestehend aus Zirkoniumoxid, Hafniumoxid und/oder Aluminiumoxid ausgewählt ist.

6. Kondensatorstruktur (CS) nach einem der Ansprüche 1 bis 5, wobei eine Stickstoffdotierungskonzentration sowohl in der dritten unteren Grenzflächenschicht (173) als auch in der dritten oberen Grenzflächenschicht (193) höher ist als eine Stickstoffdotierungskonzentration in dem dielektrischen Kondensatorfilm (180).

7. Integrierte Schaltungsvorrichtung (10), aufweisend:
die Kondensatorstruktur (CS) nach einem der Ansprüche 1 bis 6, die mit einem Transistor auf dem Substrat (110) elektrisch verbunden ist.

## Revendications

1. Structure de condensateur (CS) comprenant :
une pluralité d'électrodes inférieures (170) sur un substrat (110) ;
un support (SPT) entre la pluralité d'électrodes inférieures (170) ;
une électrode supérieure (190) sur la pluralité d'électrodes inférieures (170) ;
un film diélectrique de condensateur (180) entre la pluralité d'électrodes inférieures (170) et l'électrode supérieure (190) ;
un film d'interface inférieur (170L) entre la pluralité d'électrodes inférieures (170) et le film diélectrique de condensateur (180), le film d'interface inférieur (170L) présentant une structure multicouche à concentrations de dopage à l'azote différentes ; et
un film d'interface supérieur (190L) entre l'électrode supérieure (190) et le film diélectrique de condensateur (180), le film d'interface supérieur (190L) présentant une structure multicouche à concentrations de dopage à l'azote différentes, et
dans laquelle le film d'interface inférieur (170L) comprend
une première couche d'interface inférieure (171) comprenant un oxyde métallique dopé avec une impureté,
une deuxième couche d'interface inférieure (172) comprenant un matériau identique à un matériau de la première couche d'interface inférieure (171) et dopé à l'azote, et
une troisième couche d'interface inférieure (173) comprenant un matériau identique à un matériau du film diélectrique de condensateur (180) et dopé à l'azote, les première à troisième couches d'interface inférieures (171-173) étant empilées successivement sur la pluralité d'électrodes inférieures (170), et
dans laquelle le film d'interface supérieur (190L) comprend
une première couche d'interface supérieure (191) comprenant un oxyde métallique,
une deuxième couche d'interface supérieure (192) comprenant un matériau identique à un matériau de la première couche d'interface supérieure (191) et dopé à l'azote, et
une troisième couche d'interface supérieure (193) comprenant un matériau identique au matériau du film diélectrique de condensateur (180) et dopé à l'azote, les première à troisième couches d'interface supérieures (191-193) étant empilées successivement sur l'électrode supérieure (190), et
dans laquelle l'oxyde métallique contenu dans la première couche d'interface inférieure (171) comprend de l'oxyde de titane,
l'impureté contenue dans la première couche d'interface inférieure (171) comprend un élément pentavalent, et
une concentration de dopage à l'azote dans la deuxième couche d'interface inférieure (172) est supérieure à une concentration de dopage à l'azote dans la première couche d'interface inférieure (171).

2. Structure de condensateur (CS) selon la revendication 1, dans laquelle l'impureté contenue dans la première couche d'interface inférieure (171) comprend au moins un parmi vanadium, V, niobium, Nb, tantale, Ta, phosphore, P, et antimoine, Sb.

3. Structure de condensateur (CS) selon l'une quelconque des revendications 1 à 2, dans laquelle l'oxyde métallique contenu dans la première couche d'interface supérieure (191) comprend au moins un parmi l'oxyde de titane, l'oxyde de tantale et l'oxyde de niobium.

4. Structure de condensateur (CS) selon l'une quelconque des revendications 1 à 3, dans laquelle une concentration de dopage à l'azote dans la deuxième couche d'interface supérieure (192) est supérieure à une concentration de dopage à l'azote dans la première couche d'interface supérieure (191).

5. Structure de condensateur (CS) selon l'une quelconque des revendications 1 à 4, dans laquelle le film diélectrique de condensateur (180) comprend au moins un oxyde choisi dans le groupe constitué de l'oxyde de zirconium, de l'oxyde d'hafnium et de l'oxyde d'aluminium.

6. Structure de condensateur (CS) selon l'une quelconque des revendications 1 à 5, dans laquelle une concentration de dopage à l'azote dans chacune de la troisième couche d'interface inférieure (173) et de la troisième couche d'interface supérieure (193) est supérieure à une concentration de dopage à l'azote dans le film diélectrique de condensateur (180).

7. Dispositif de circuit intégré (10) comprenant :
la structure de condensateur (CS) selon l'une quelconque des revendications 1 à 6, qui est électriquement reliée à un transistor sur le substrat (110).
